# DEMANDE DE BREVET EUROPEEN

(11) **EP 0 524 040 A1**
(43) Date de publication de la demande: **20.01.1993**
(21) Numéro de dépôt: 92401760.1
(22) Date de dépôt: 24.06.1992
(51) Int. Cl.: H05K 7/14

(54) **Dispositif pour verrouiller dans un chassis un tiroir pour carte(s) électroniques**

(30) Priorité: 25.06.1991 FR 9107769; 03.07.1991 FR 9108288
(71) Demandeur: AUDIO VISUEL SYSTEMES, F-93100 Montreuil Sous Bois (FR)
(72) Inventeur: Gelez, François, F-94360 Bry sur Marne (FR); Aube, Joel, F-27490 Ecardenville sur Eure (FR); Dector, Gérard, F-61320 Carrouges (FR)
(74) Mandataire: Colas, Jean-Pierre

(57) **Abrégé**

Ce dispositif de verrouillage dans un châssis de la face avant (2) d'un tiroir (1) pour carte(s) électronique(s) comprend un pêne (9) monté coulissant sur la face avant entre une position de verrouillage dans une gâche (11) portée par le châssis et une position de déverrouillage, et un levier (10) articulé adapté pour déplacer ledit pêne (9) entre lesdites positions de verrouillage et de déverrouillage lorsqu'il est basculé respectivement entre une position sensiblement rabattue le long de ladite face avant (2) et une position de préhension dans laquelle il fait saillie par rapport à ladite face avant.

Le levier (10) est articulé sur le pêne (9) et mobile en translation avec celui-ci, et le levier (10) et la face avant (2) comportent des moyens complémentaires qui coopèrent pour déplacer ledit pêne (9) et ledit levier (10) en translation lorsque ledit levier est basculé entre ladite position rabattue et ladite position de préhension.

## Description

La présente invention concerne un dispositif pour verrouiller dans un châssis la face avant d'un tiroir pour carte(s) électronique(s), ainsi qu'un tiroir équipé d'un tel dispositif.

Il est connu, notamment dans le domaine des équipements électroniques professionnels, de monter dans des châssis un certain nombre de tiroirs comportant chacun une ou plusieurs cartes électroniques, par exemple des circuits imprimés portant des composants électroniques discrets et/ou des circuits intégrés. Ces châssis sont généralement équipés dans leur fond de connecteurs permettant de connecter à l'extérieur les circuits électroniques contenus dans les cartes. Lorsqu'ils ont des dimensions importantes, ces équipements peuvent être constitués d'une baie réunissant plusieurs châssis disposés les uns au-dessus des autres et/ou les uns à côté des autres.

Il existe un grand nombre d'applications dans lesquelles les tiroirs doivent pouvoir être facilement mis en place dans les châssis et retirés de ces derniers. Tel est le cas, notamment, lorsque les tiroirs constituent des modules ayant des fonctions spécifiques (traitement de signal dans le domaine audio et vidéo par exemple) qui sont susceptibles d'être assemblés suivant un grand nombre de combinaisons différentes pour répondre à un besoin spécifique et temporaire d'un utilisateur. Il est alors commode de prévoir sur les tiroirs et le châssis des moyens complémentaires de verrouillage qui permettront, sans faire appel à aucun outil, de manipuler facilement les tiroirs.

Le document DE-A-3 636 088 décrit un dispositif de verrouillage dans lequel les cadres haut et bas d'un châssis sont équipés dans leur partie frontale d'une gâche de forme particulière adaptée pour coopérer avec un pêne de forme complémentaire porté par la face avant d'un tiroir ou équivalent équipé d'une carte électronique. Le pêne est susceptible de coulisser perpendiculairement à la face avant entre une position de verrouillage dans la gâche et une position de déverrouillage sous l'effet d'un levier articulé sur la face avant et adapté pour déplacer le pêne entre les positions de verrouillage et de déverrouillage lorsqu'il est basculé respectivement entre une position sensiblement rabattue le long de la face avant et une position de préhension dans laquelle il fait saillie par rapport à cette même face avant.

Ce dispositif de verrouillage de la technique antérieure a cependant pour inconvénient de présenter une réalisation relativement complexe et encombrante qui fait appel à un boîtier rapporté sur la face avant et contenant un levier articulé dans ce boîtier et un ressort emprisonné dans celui-ci et coopérant avec le pêne pour le solliciter élastiquement dans une direction perpendiculaire à son mouvement de coulissement. De plus, le châssis ne peut pas être d'un modèle standard car il doit être équipé à des emplacements définis de gâches de configuration appropriée pour coopérer avec les pênes portés par les tiroirs ou équivalents.

L'expression "châssis standard" désigne ici une ossature de forme générale parallélépipédique constituée de profilés et dont au moins les profilés supérieur et inférieur de la partie avant présentent une rangée de trous taraudés régulièrement espacés les uns des autres. Il est classique de fixer des tiroirs dans ces châssis standards grâce à des vis reçues dans les trous taraudés à travers des orifices ménagés en partie haute et basse de la face avant des tiroirs. De tels châssis standards sont naturellement beaucoup moins coûteux que des châssis spécifiques équipés de gâches comme décrit au brevet DE-A-3 636 088, par contre le mode de verrouillage et déverrouillage des tiroirs par vis s'avère beaucoup moins commode lorsque les tiroirs sont manipulés fréquemment.

L'invention vise à fournir un dispositif de verrouillage de la face avant d'un tiroir dans un châssis qui soit d'une réalisation simple et peu coûteuse, d'un encombrement réduit et d'un maniement aisé. Un autre but de l'invention est de fournir un dispositif de verrouillage qui puisse être utilisé avec des châssis standards dépourvus d'origine de tout moyen de verrouillage des tiroirs, à l'exception de trous taraudés ou autres moyens de fixation conventionnels équivalents.

A cet effet, l'invention a pour objet un dispositif pour verrouiller dans un châssis la face avant d'un tiroir pour carte(s) électronique(s), comprenant une gâche portée par ledit châssis, un pêne porté par ladite face avant pour coulisser entre une position de verrouillage dans ladite gâche et une position de déverrouillage, et un levier articulé adapté pour déplacer ledit pêne entre lesdites positions de verrouillage et de déverrouillage lorsqu'il est basculé respectivement entre une position sensiblement rabattue le long de ladite face avant et une position de préhension dans laquelle il fait saillie par rapport à ladite face avant, caractérisé en ce que :
- ledit levier est articulé sur ledit pêne et mobile en translation avec celui-ci,
- ledit levier et la face avant comportent des moyens complémentaires qui coopèrent pour déplacer ledit pêne et ledit levier en translation lorsque ledit levier est basculé entre ladite position rabattue et ladite position de préhension. Ce dispositif de verrouillage est d'une réalisation particulièrement simple puisque le levier est porté par le pêne et mobile en translation avec celui-ci, aucune pièce n'étant ainsi articulée sur la face avant du tiroir.

D'autres caractéristiques et avantages de l'invention ressortiront de la description qui va suivre de modes de réalisation donnés à titre d'exemples et illustrés par les dessins annexés sur lesquels :
- la figure 1 est une vue en perspective éclatée d'un tiroir comportant un dispositif de verrouillage selon l'invention ;
- la figure 2 est une vue en perspective éclatée, à plus grande échelle, du dispositif de verrouillage équipant le tiroir de la figure 1 ;
- la figure 3 est une vue en élévation frontale du levier ou poignée du dispositif de verrouillage des figures 1 et 2 ;
- la figure 4 est une vue en coupe suivant la ligne IV-IV de la figure 3 ;
- la figure 5 est une vue en élévation frontale de la partie inférieure de la face avant des figures 1 et 2 ;
- la figure 6 est une vue en coupe suivant la ligne VI-VI de la figure 5 ;
- la figure 7 est une vue partielle en perspective du tiroir de la figure 1 en position montée dans un châssis ;
- la figure 8 est une vue en élévation frontale de la face avant du tiroir de la figure 7 ;
- la figure 9 est une vue en coupe suivant la ligne IX-IX de la figure 8 ;
- les figures 10A à 10D sont des vues en coupe partielle du dispositif de verrouillage montrant le levier et le pêne dans différentes positions de fonctionnement ;
- la figure 11 est une vue partielle en coupe longitudinale du boîtier de la figure 1 ; et
- la figure 12 est une vue en perspective éclatée similaire à la figure 1 montrant la face avant d'un tiroir selon un second mode de réalisation de l'invention.

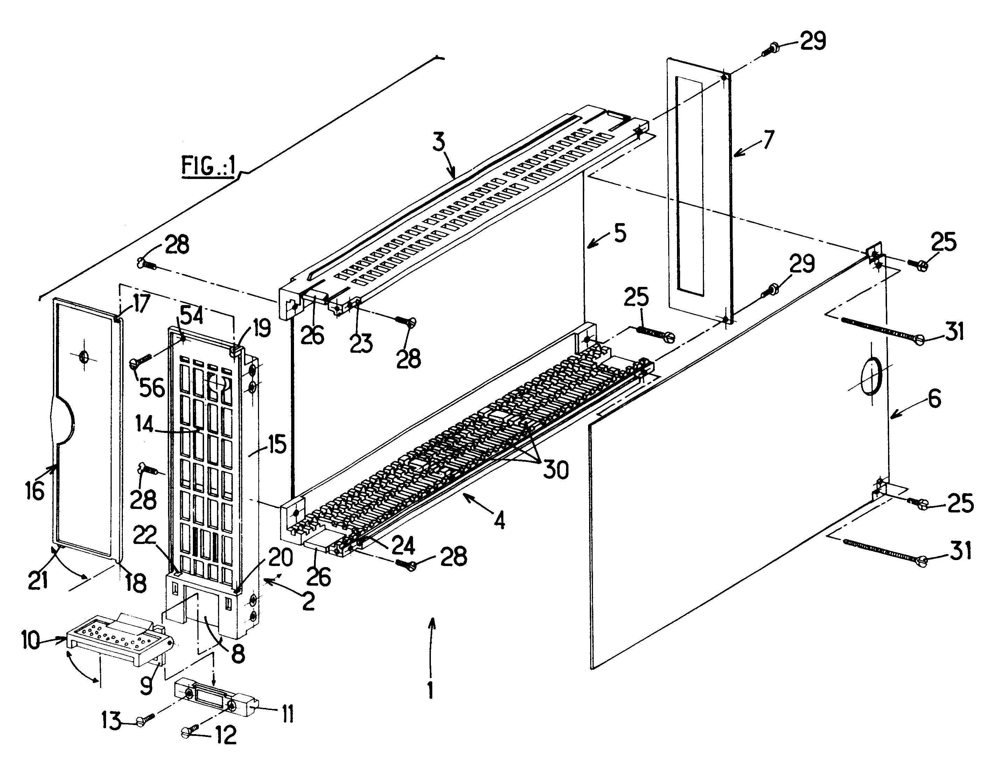

En se reportant à la figure 1, un tiroir 1 destiné à recevoir des cartes électroniques (non représentées) présente la forme d'un boîtier parallélépipédique comportant une face avant 2, des flancs supérieur 3 et inférieur 4 réunis à une première paroi latérale 5, une deuxième paroi latérale 6, et une plaque arrière de fermeture 7 facultative.

La face avant 2 présente en partie basse une rainure à section en T 8 s'étendant à partir de son bord inférieur parallèlement au plan d'ensemble de ladite face avant et dans laquelle peut coulisser un pêne 9 sur lequel est articulé un levier 10 faisant également office de poignée de préhension. La rainure 8 est ouverte à son extrémité adjacente au bord inférieur de la face avant 2. Le pêne 9 peut coulisser dans la rainure 8 entre une position déverrouillée et une position verrouillée dans laquelle il vient faire saillie dans une gâche 11 destinée à être fixée au moyen de vis 12 et 13 à un châssis (non représenté sur la figure 1) destiné à recevoir le tiroir 1.

La face avant 2 est réalisée en matière plastique conductrice de l'électricité et présente, au-dessus de sa partie inférieure comportant la rainure 8, une fenêtre constituée d'une grille 14 dont les barreaux peuvent être tronçonnés à volonté au moyen d'une pince coupante ou similaire de manière à permettre la mise en place, à un ou plusieurs emplacements voulus derrière la grille 14, de composants électroniques tels que des diodes électroluminescentes. Les barreaux de la grille 14 doivent être suffisamment petits pour pouvoir être facilement sectionnés, tout en ayant une largeur suffisante pour permettre le collage sur l'ensemble de la grille 14 d'une étiquette (non représentée) d'identification et de personnalisation du tiroir. Les composants précités peuvent être portés par un circuit imprimé (non représenté) monté dans le tiroir comme cela sera expliqué dans la suite ou reçu dans une jupe 15 faisant saillie vers l'arrière à partir de la face avant 2. La face avant 2 est complétée par une porte 16 en matière plastique comportant le long d'un de ses bords longitudinaux deux tétons alignés 17 et 18 reçus respectivement dans des logements 19 et 20 venus de moulage avec la face avant 2 pour former des charnières. La porte 16 peut être immobilisée en position fermée grâce à un téton 21 destiné à être engagé élastiquement dans un logement 22 de la face avant 2.

Les flancs supérieur 3 et inférieur 4 se présentent sous la forme de grilles en matière plastique conductrice de l'électricité qui sont soudées à la paroi latérale métallique 5. Les flancs 3 et 4 présentent respectivement des rainures longitudinales 23 et 24 tournées l'une vers l'autre et entre lesquelles est reçue l'autre paroi latérale 6, également métallique. De manière facultative, les parois 5 et 6 peuvent être fixées aux flancs 3 et 4 par un ensemble de vis désignées par la référence 25.

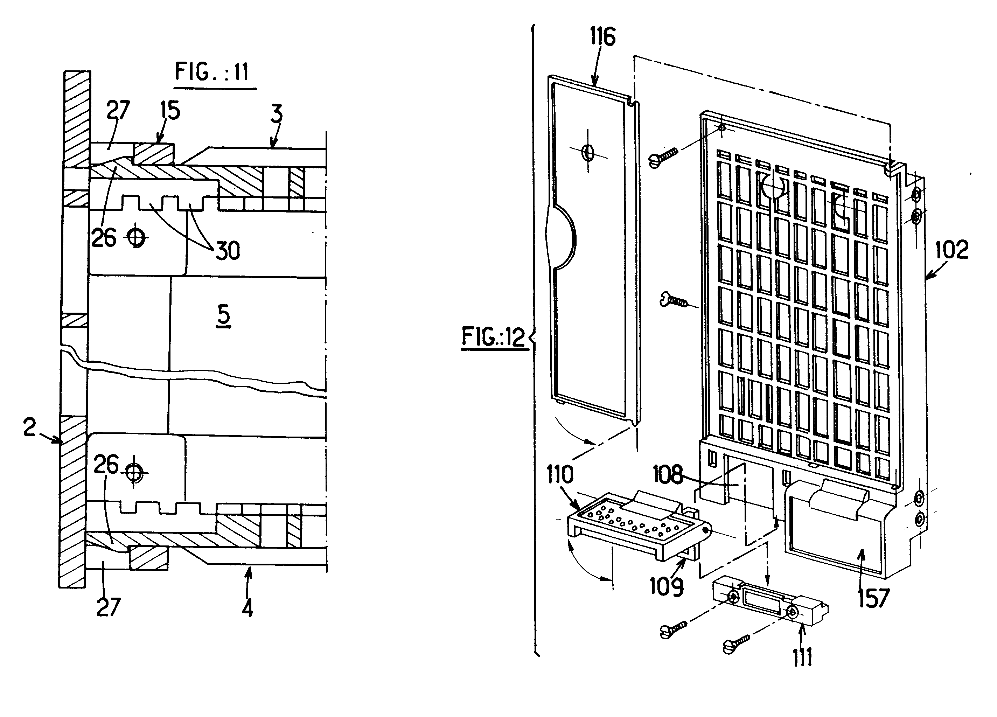

La face avant 2 est emboîtée par sa jupe 15 sur l'extrémité correspondante des flancs 3 et 4. A cet effet, les flancs 3 et 4 portent des pattes élastiques 26 en forme de crochets et les bords supérieur et inférieur de la jupe 15 sont pourvus de lumières 27 (voir également la figure 11) dans lesquelles peuvent venir s'engager les crochets 26. De manière facultative, cette fixation par encliquetage de la face avant 2 sur les éléments solidarisés 3, 4 et 5 du tiroir peut être complétée au moyen de vis désignées dans leur ensemble par la référence 28. Dans la position montée de la face avant 2, les parois latérales 5 et 6 sont situées dans le prolongement des bords latéraux de la jupe 15 et sont en appui contre ceux-ci.

Ainsi que cela résulte de la description qui précède, la paroi latérale 6 peut être retirée vers l'arrière hors des glissières 23, 24 et donner ainsi accès à l'intérieur du tiroir sans avoir à démonter la face avant 2. La paroi arrière 7, qui est facultative et fixée aux flancs 3 et 4 au moyen de vis 29, ne fait pas obstacle à cette extraction vers l'arrière de la paroi latérale 6.

Les flancs 3 et 4 présentent sur leurs faces en regard un réseau de bossages 30 définissant deux jeux de rainures à angle droit, à savoir un jeu de 43 rainures transversales parallèles à la face avant 2 et un jeu de 4 rainures longitudinales perpendiculaires aux rainures transversales et à la face avant 2. Le tiroir 1 peut donc recevoir des cartes électroniques dans le sens longitudinal et/ou dans le sens transversal. De préférence, les cartes électroniques sont connectées deux à deux les unes aux autres de façon conventionnelle par des conducteurs noyés dans une bande de matière plastique et se terminant par des connecteurs enfichés dans des connecteurs correspondants des cartes. Les cartes disposées parallèlement à la face avant 2 ne nécessitent aucune fixation dans le tiroir car elles sont prises en sandwich entre les parois latérales 5 et 6. Le maintien de cartes disposées longitudinalement dans le tiroir 1 est assuré par la fixation du connecteur solidaire de ces cartes dans le tiroir au moyen de vis 31. En variante, si une plaque 7 est montée à l'arrière du tiroir, toute fixation devient inutile car les cartes sont alors prises en sandwich entre la face avant 2 et la face arrière 7.

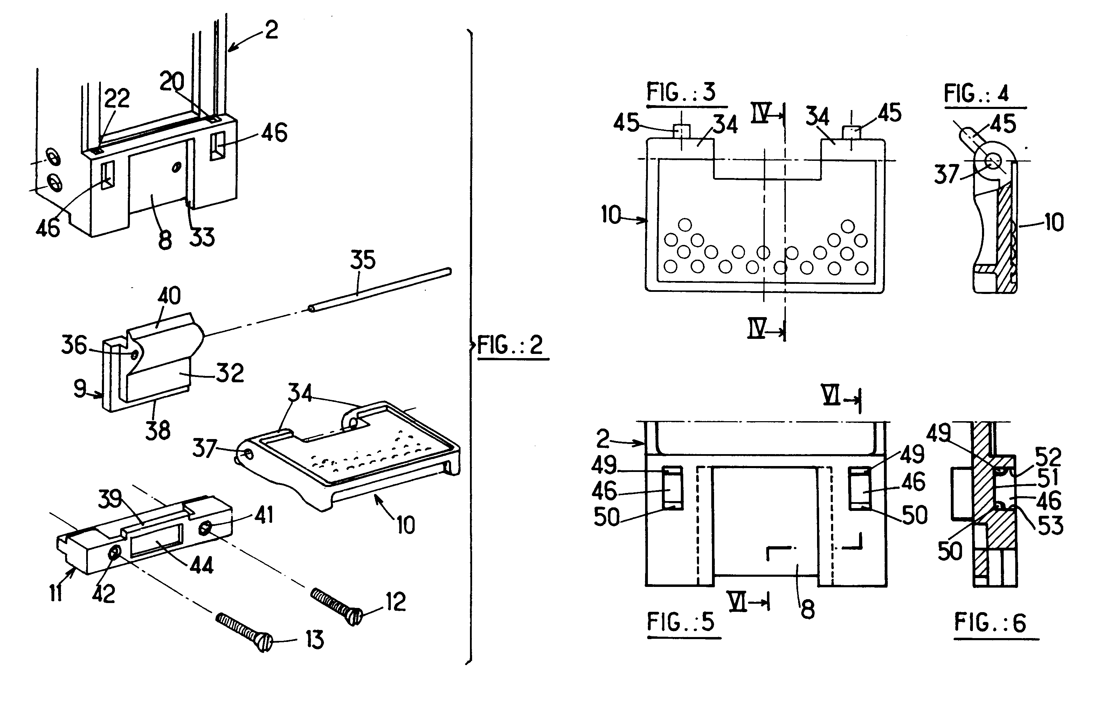

En se reportant également aux figures 2 à 10, le pêne 9 présente sur l'une de ses faces une embase 32 qui, lorsque le pêne est monté dans la rainure 8, fait saillie à travers une découpe 33 de ladite rainure. La poignée 10 forme une chape 34 et elle est reliée au pêne 9 par un axe métallique 35 s'étendant à travers des trous alignés 36 et 37 du pêne 9 et de la chape 34 respectivement.

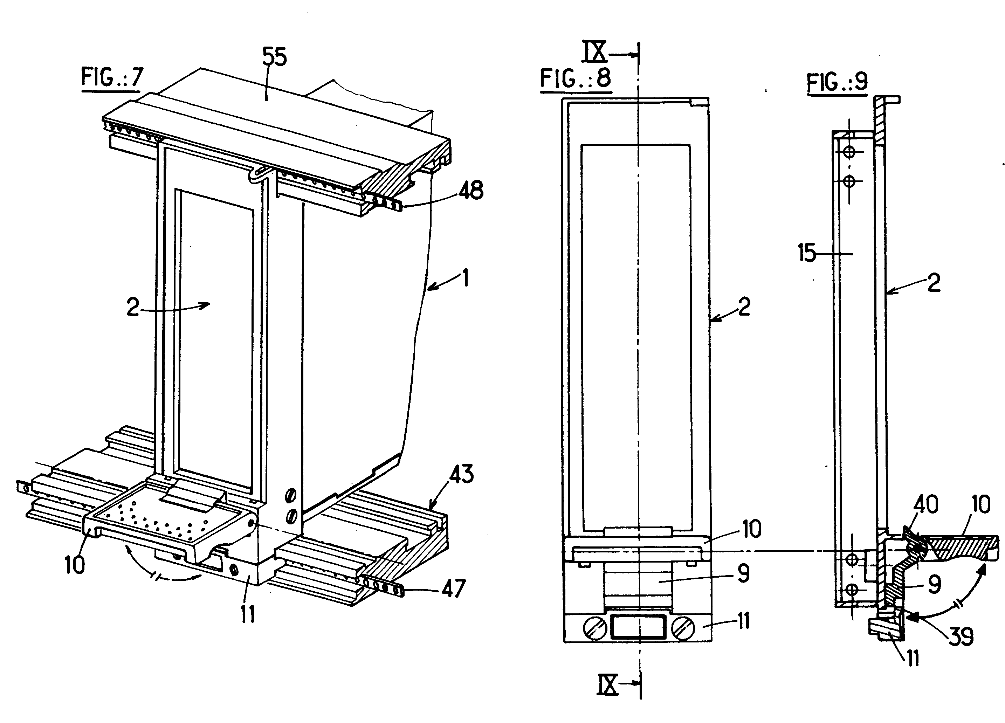

Le bord antérieur 38 du pêne 9 est destiné à venir s'engager derrière un rebord en saillie 39 de la gâche 11 dans la position de verrouillage, tandis que l'embase 32 se termine du côté opposé au bord antérieur 38 par un bec en saillie 40 adapté pour limiter le débattement de la poignée 10 au-delà de la position de préhension représentée sur les figures 7 à 9.

La gâche 11 est percée de deux trous 41 et 42 de passage des vis 12 et 13 pour sa fixation à un emplacement voulu le long d'un rail 43 du châssis comportant une réglette 47 pourvue de trous taraudés (figure 7). Sa paroi avant présente, entre les trous 41 et 42, une surface en retrait 44 destinée à recevoir une étiquette portant, par exemple, des données d'identification du tiroir destiné à être placé dans le châssis à l'emplacement défini par la gâche.

Chacune des joues de la chape 34 de la poignée 10 porte un téton 45 qui fait saillie obliquement vers l'arrière et vers la face de dessous de la poignée 10. Les deux tétons 45 de la poignée 10 sont destinés à être reçus respectivement dans deux évidements 46 ménagés dans la face avant 2 de part et d'autre de la rainure en T 8. Chaque évidement a la forme d'une rainure rectangulaire présentant à ses extrémités opposées des bossages 49 et 50 respectivement faisant saillie dans les angles formés entre le fond 51 de la rainure et ses parois d'extrémités 52 et 53 respectivement.

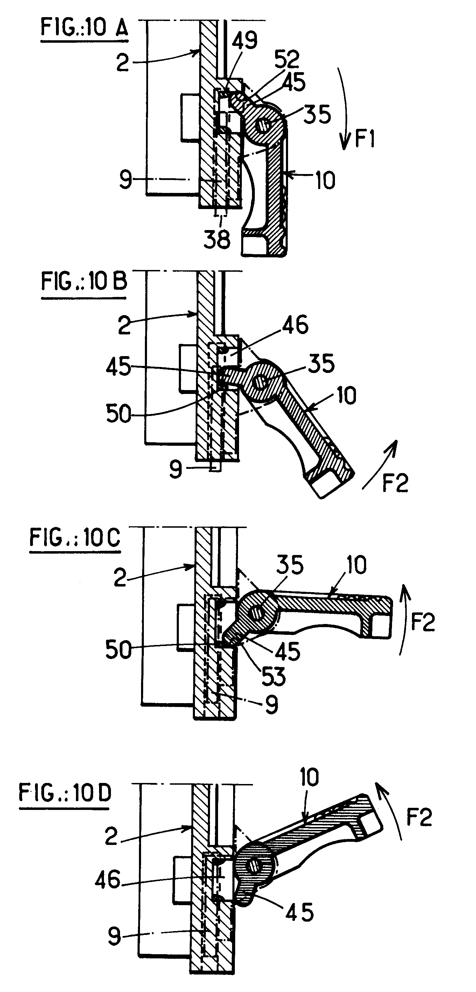

Les bossages 49 et 50 forment des surfaces de came dont le rôle sera mieux compris en se reportant aux figures 10A à 10D.

Dans la position de verrouillage représentée à la figure 10A, la poignée 10 est rabattue le long de la face avant 2 et se trouve maintenue dans cette position par le fait que chacun des tétons 45 se trouve en appui dans l'évidement correspondant entre le bossage 49 et la paroi d'extrémité 52. Tout mouvement de la poignée 10 au-delà de cette position dans le sens indiqué par la flèche F1 est interdit par le fait que le dessous de la poignée est alors en appui contre la face avant 2. Dans cette position, le bord avant 38 du pêne 9 fait saillie hors de la rainure en T 8. Si un tiroir est en position dans un châssis au droit d'une gâche 11 comme représenté à la figure 7, et si la poignée est en position de verrouillage comme représenté à la figure 10A, le bord avant 38 du pêne 9 se trouve engagé derrière le rebord 39 de la gâche 11 et verrouille ainsi le tiroir en position dans le châssis.

Pour déverrouiller le tiroir, on bascule la poignée 10 vers le haut dans le sens indiqué par la flèche F2, ce qui implique le franchissement d'un premier point dur lorsque l'extrémité des tétons 45 passe sur le sommet des bossages 49. Ce franchissement de point dur a lieu par déformation élastique des différentes pièces 2, 9 et 10, grâce à un choix approprié de la matière plastique dont elles sont constituées et de leurs tolérances de fabrication. Pendant la poursuite du mouvement de rotation de la poignée 10 dans le sens de la flèche F2, le pêne 9 demeure immobile tant que les tétons 45 tournent librement dans les évidements 46. Lorsque les tétons 45 rencontrent les bossages 50, la poursuite du basculement de la poignée 10 dans le sens de la flèche F2 a pour effet de repousser vers le haut, parallèlement à la face avant 2, l'axe d'articulation 35 et le pêne 9 lié à celui-ci. Le mouvement du pêne 9 se poursuit jusqu'à ce que son bord postérieur vienne en appui contre le fond de la rainure 8. La poignée 10 offre alors une résistance mais, en poursuivant son basculement dans le sens de la flèche F2, un nouveau franchissement de point dur a lieu lorsque les extrémités des tétons 45 passent sur le sommet des bossages 50 par déformation élastique. La poignée 10 se trouve alors immobilisée dans la position de déverrouillage représentée à la figure 10C, par le fait que l'extrémité de chacun des tétons 45 est engagée légèrement à force entre le bossage 50 et la paroi d'extrémité adjacente 53. Dans cette position, la poignée 10 s'étend sensiblement perpendiculairement à la face avant 2 et offre un moyen de préhension permettant aisément d'extraire ou de mettre en place un tiroir dans le châssis. Comme on le voit également sur la figure 9, dans cette position le pêne 9 est suffisamment rétracté pour pouvoir passer au-dessus du rebord 39 de la gâche 11.

Le pêne 9 est monté librement coulissant dans la rainure 8 parallèlement à la face avant 2 et il est retenu dans celle-ci uniquement par l'engagement des tétons 45 dans les évidements 46. Toutefois, le pêne 9 peut être entièrement dégagé de la rainure 8 en poursuivant, à partir de la position de la figure 10C, le mouvement de la poignée 10 vers le haut dans le sens de la flèche F2 jusqu'à ce que, par déformation élastique, les tétons 45 sortent complètement des évidements 46 comme représenté à la figure 10D. Pour libérer complètement le pêne 9 et la poignée 10, il suffit de faire coulisser vers le bas la poignée 10 en la maintenant dans la position représenté sur la figure 10D jusqu'à ce que le pêne 9 sorte complètement de la rainure 8 comme représenté notamment sur la vue éclatée de la figure 1.

La mise en place d'un pêne 9 dans une face avant 2 a lieu en effectuant les opérations inverses de celles qui viennent d'être décrites. On notera également que lorsqu'on passe de la position de préhension ou de déverrouillage (figure 10C) à la position de verrouillage (figure 10A), la descente du pêne 9 résulte de la venue en appui des tétons 45 contre les bossages 49, ce qui a pour effet de repousser l'axe d'articulation 35 vers le bas parallèlement à la face avant 2.

Le dispositif de verrouillage qui vient d'être décrit ne fait appel qu'à un nombre très réduit de pièces, à savoir la face avant 2, le pêne 9, la poignée 10, la gâche 11 et l'axe 35. L'axe 35 est une simple tige métallique, tandis que la face avant 2, le pêne 9, la poignée 10 et la gâche 11 peuvent être réalisés en matière plastique polycarbonate par une opération de moulage par injection. La fabrication de ces pièces et leur assemblage sont par conséquent extrêmement simples et peu coûteux, et le remplacement éventuel d'une pièce détériorée est particulièrement aisé.

On notera également qu'une face avant 2 seule (c'est-à-dire sans les éléments 3, 4, 5, 6 et 7) peut être verrouillée sur un châssis pour habiller celui-ci dans le cas où il n'est équipé que partiellement en tiroirs. A cet effet, un trou 54 (figure 1) est prévu en partie haute de la face avant 2 pour permettre sa fixation au moyen d'une vis 56 dans un trou taraudé d'une réglette 48 faisant partie d'un rail supérieur 55 du châssis (figure 7). Toutefois, afin d'éviter des manipulations de vis, en variante la face avant 2 peut être pourvue en partie haute d'un deuxième dispositif de verrouillage identique à celui décrit ci-dessus. Lorsque la face avant 2 fait partie d'un tiroir, cette fixation en partie haute n'est pas nécessaire puisque le tiroir maintenu par des glissières dans le châssis ne peut se déplacer qu'en translation.

La figure 12 illustre une seconde forme de réalisation de l'invention dans laquelle les mêmes numéros de référence que sur les figures 1 à 11, mais augmentées du nombre 100, ont été utilisées pour désigner des organes correspondants. Dans cette variante, la face avant est destinée à équiper des tiroirs ayant une largeur qui est le double de celle des tiroirs du mode de réalisation des figures 1 à 11. Toutefois, cette face avant 102 ne comporte qu'un seul dispositif de verrouillage placé à côté d'une pièce 157 venue de moulage et qui, pour des raisons purement esthétiques, présente le même aspect que le dispositif de verrouillage lorsque la poignée de celui-ci est rabattue en position verrouillée. De préférence, cette pièce 157 a également une fonction de détrompage en ce sens qu'un tiroir double ne pourra pas être mis en place dans un châssis si, au droit de la pièce 157 une gâche est fixée au rail inférieur 43 du châssis. Pour ce faire, le bord inférieur de la face avant présente une nervure en saillie vers le bas (qui se trouve masquée par la pièce 157 et par conséquent non visible sur la figure 12). Si une gâche 11 est fixée au rail 43 au droit de la pièce 157, cette nervure vient buter contre le rebord 39 de la gâche 11 et interdit par conséquent d'engager à fond le tiroir dans le châssis.

Il va de soi que les modes de réalisation décrits ne sont que des exemples et l'on pourrait les modifier, notamment par substitution d'équivalents techniques, sans sortir pour cela du cadre de l'invention. C'est ainsi, par exemple, que la rainure 8 peut être formée entre une partie plane de la face avant 2 et une pièce rapportée et fixée sur celle-ci par tout moyen approprié tel que collage, vissage, etc...

## Revendications

1. Dispositif pour verrouiller dans un châssis la face avant d'un tiroir pour carte(s) électronique(s), comprenant une gâche portée par ledit châssis, un pêne porté par ladite face avant pour coulisser entre une position de verrouillage dans ladite gâche et une position de déverrouillage, et un levier articulé adapté pour déplacer ledit pêne entre lesdites positions de verrouillage et de déverrouillage lorsqu'il est basculé respectivement entre une position sensiblement rabattue le long de ladite face avant et une position de préhension dans laquelle il fait saillie par rapport à ladite face avant, caractérisé en ce que :
- ledit levier (10 ; 110) est articulé sur ledit pêne (9 ; 109) et mobile en translation avec celui-ci,
- ledit levier (10 ; 110) et la face avant (2 ; 102) comportent des moyens complémentaires (45, 46) qui coopèrent pour déplacer ledit pêne (9 ; 109) et ledit levier (10 ; 110)en translation lorsque ledit levier est basculé entre ladite position rabattue et ladite position de préhension.

2. Dispositif selon la revendication 1, caractérisé en ce que ledit pêne (9 ; 109) est monté coulissant dans une rainure (8 ; 108) ménagée sur ladite face avant (2 ; 102) à partir d'un bord de celle-ci.

3. Dispositif selon la revendication 2, caractérisé en ce que lesdits moyens complémentaires comprennent au moins un téton (45) en saillie sur ledit levier (10 ; 110) et deux surfaces de came (49, 50) ménagées sur ladite face avant (2 ; 102), ledit téton (45) étant adapté pour prendre appui contre lesdites surfaces de came et repousser ledit levier et ledit pêne dans lesdites positions de verrouillage et de déverrouillage lorsque ledit levier (10, 110) est basculé respectivement dans lesdites positions rabattue et de préhension.

4. Dispositif selon la revendication 3, caractérisé en ce que lesdites surfaces de came sont constituées par deux bossages (49, 50) adjacents respectivement à deux extrémités opposées (52, 53) d'un logement de ladite face avant (2 ; 102) et coopérant avec ledit téton (45) pour former deux points durs de maintien dudit levier (10, 110) respectivement dans lesdites positions rabattue et de préhension.

5. Dispositif selon la revendication 4, caractérisé en ce que ledit téton (45) et ledit logement (46) constituent des moyens de retenue dudit pêne (9 ; 109) dans ladite rainure (8 ; 108) et en ce que ledit téton (45) est conformé pour être dégagé par déformation élastique hors dudit logement (46) par basculement dudit levier, au-delà de ladite position de préhension, vers une position de libération de pêne, et engagé par déformation élastique dans ledit logement par basculement dudit levier vers ladite position de préhension, à partir de ladite position de libération de pêne.

6. Dispositif selon l'une quelconque des revendications 4 et 5, caractérisé en ce que ladite face avant (2) comporte deux logements (46) ménagés de part et d'autre de ladite rainure (8) et le levier (9) porte deux tétons (45) adaptés pour coopérer respectivement avec lesdits logements.

7. Dispositif selon l'une quelconque des revendications 2 à 6, caractérisé en ce que ledit levier est articulé sur une embase (32) dudit pêne (9) adaptée pour faire saillie à travers une découpe (33) de ladite rainure (8).

8. Dispositif selon l'une quelconque des revendications 1 à 7, caractérisé en ce que ladite gâche (11) est une pièce amovible fixée audit châssis.

9. Dispositif selon la revendication 8, caractérisé en ce que ladite gâche (11), ledit pêne (9), ledit levier (10) et ladite face avant (2) sont des pièces moulées en matière plastique.

10. Tiroir pour cartes électroniques destiné à être monté à coulissement dans un châssis, caractérisé en ce qu'il comprend au moins un dispositif de verrouillage selon l'une quelconque des revendications 1 à 9.

11. Tiroir selon la revendication 10, caractérisé en ce qu'il comprend un flanc supérieur (3) et un flanc inférieur (4) pourvus de rainures orthogonales (30) pour le montage sélectif de cartes électroniques parallèlement et perpendiculairement à ladite face avant (2).

12. Tiroir selon la revendication 10, caractérisé en ce que ladite face avant (2 ; 102) est fixée par encliquetage à au moins un flanc (3, 4) dudit tiroir.
